# EUROPÄISCHE PATENTSCHRIFT

(11) **EP 2 850 661 B1**
(45) Veröffentlichungstag und Bekanntmachung des Hinweises auf die Patenterteilung: **17.02.2016**
(21) Anmeldenummer: 13728840.3
(22) Anmeldetag: 06.05.2013
(51) Int. Cl.: H01L 31/0224, H01L 31/0747

(54) **HETEROKONTAKT-SOLARZELLE UND VERFAHREN ZU DEREN HERSTELLUNG**
HETERO-CONTACT SOLAR CELL AND METHOD FOR THE PRODUCTION THEREOF
CELLULE SOLAIRE À HÉTÉROCONTACT ET SON PROCÉDÉ DE FABRICATION

(30) Priorität: 16.05.2012 DE 102012104289
(43) Veröffentlichungstag der Anmeldung: 25.03.2015
(73) Patentinhaber: Meyer Burger (Germany) AG, 09337 Hohenstein-Ernstthal (DE)
(72) Erfinder: WAHLI, Guillaume, CH-1024 Ecublens (CH); CITARELLA, Giuseppe, 09112 Chemnitz (DE); WÜNSCH, Frank, 10787 Berlin (DE); ERDMANN, Matthias, 70329 Stuttgart (DE); WEINKE, Martin, 09569 Oederan (DE)
(74) Vertreter: Steiniger, Carmen
(86) Internationale Anmeldenummer: PCT/IB2013/053610
(87) Internationale Veröffentlichungsnummer: WO 2013/171619

(56) Entgegenhaltungen:
- EP-A1- 1 696 492
- WO-A2-2010/058976
- JP-A- 2004 228 281
- JP-A- 2004 289 058
- JP-A- 2005 101 239
- US-A1- 2011 036 399

## Beschreibung

Die vorliegende Erfindung betrifft eine Heterokontakt-Solarzelle, in deren Vorderseite ein Einfall von Solarstrahlung vorgesehen ist, mit einem aus einem kristallinen Halbleitermaterial eines ersten Leitfähigkeitstyps bestehenden Absorber, einer vorderseitig der Heterokontakt-Solarzelle vorgesehenen, höher als der Absorber dotierten amorphen Halbleiterschicht des ersten Leitfähigkeitstyps, einer vorderseitig auf der dotierten amorphen Halbleiterschicht des ersten Leitfähigkeitstyps vorgesehenen elektrisch leitfähigen, transparenten Vorderseitenleitungsschicht, einer auf der Vorderseite der Heterokontakt-Solarzelle befindlichen, voneinander beabstandete Kontaktstrukturen aufweisenden Vorderseitenkontaktierung, einem rückseitig der Heterokontakt-Solarzelle vorgesehenen Emitter eines zweiten, zum ersten Leitungstyp entgegengesetzten Leitfähigkeitstyps, und einer auf der Rückseite der Heterokontakt-Solarzelle angeordneten Rückseitenkontaktierung. Die Erfindung betrifft ferner ein Verfahren zum Herstellen einer Heterokontakt-Solarzelle, in deren Vorderseite ein Einfall von Solarstrahlung vorgesehen ist, wobei ein Absorber aus einem kristallinen Halbleitermaterial eines ersten Leitfähigkeitstyps bereitgestellt wird, vorderseitig der Heterokontakt-Solarzelle eine höher als der Absorber dotierte amorphe Halbleiterschicht des ersten Leitfähigkeitstyps abgeschieden wird, vorderseitig auf der dotierten amorphen Halbleiterschicht des ersten Leitungstyps eine elektrisch leitfähige, transparente Vorderseitenleitungsschicht abgeschieden wird, auf der Vorderseite der Heterokontakt-Solarzelle eine voneinander beabstandete Kontaktstrukturen aufweisende Vorderseitenkontaktierung erzeugt wird, rückseitig der Heterokontakt-Solarzelle ein Emitter eines zweiten, zum ersten Leitungstyp entgegengesetzten Leitfähigkeitstyps abgeschieden wird, und auf der Rückseite der Heterokontakt-Solarzelle eine Rückseitenkontaktierung erzeugt wird.

Standard-Heterokontakt-Solarzellen weisen einen Aufbau auf, bei welchem auf der lichtzugewandten Seite eines zentralen Absorbers aus kristallinem, n-dotierten Silizium ein Emitter aus amorphem, p-dotierten Silizium und eine transparente leitfähige Oxidschicht (TCO-Schicht) unter fingerförmigen Frontkontakten angeordnet ist. Durch den auf der lichtzugewandten Vorderseite des Absorbers vorgesehenen Emitter wird Strahlung absorbiert, welche den Absorber nicht mehr erreichen kann. Auf der lichtabgewandten Rückseite der Heterokontakt-Solarzelle ist auf dem Absorber eine amorphe, n⁺-dotierte Siliziumschicht zur Ausbildung eines Minoritätsladungsträger reflektierenden Oberflächenfeldes ("Back Surface Field", BSF) vorgesehen, auf welcher sich eine ganzflächige Rückseitenkontaktierung befindet.

Um die Verluste bei Heterokontakt-Solarzellen mit einer konventionellen Schichtstrukturgeometrie mit einem Emitter auf der lichtzugewandten Vorderseite des Absobers zu verringern, sind im Stand der Technik unterschiedliche Ansätze bekannt. Einer dieser Ansätze besteht darin, den Emitter auf der lichtabgewandten Seite des Absorbers anzuordnen. In der Druckschrift US 7,199,395 B2 wird der rückseitig vorgesehene Emitter streifenförmig ausgebildet und mit amorphen Streifen gegensätzlicher Dotierung unter Ausbildung einer interdigitalen (interdigitated) Struktur verschachtelt. Die unterschiedlich dotierten Bereiche werden durch ohmsche Kontaktierungsstrukturen auf der lichtabgewandten Rückseite der Solarzelle kontaktiert. Da hier sowohl die Emitter- als auch die Back-Surface-Field-Strukturen auf der Rückseite der Solarzelle angeordnet und dort kontaktiert werden müssen, ist die hiermit verbundene Technologie sehr aufwändig. Ferner ist auch bei derartigen Solarzellen auf der lichtzugewandten Solarzellenvorderseite eine zusätzliche Passivierungsschicht vorzusehen, die der Verringerung der Rekombination von lichterzeugten Ladungsträgern auf der Vorderseite der Solarzelle unter Ausbildung eines sogenannten FSF ("Front Surface Field") dient.

Ein anderer Ansatz zur Verringerung der durch vorderseitig angeordnete Emitter erzeugten Verluste wird in der Druckschrift WO 2006/111138 A1 verfolgt. Die in dieser Druckschrift beschriebene Heterokontakt-Solarzelle weist im Vergleich zu bis dato bekannten Heterokontakt-Solarzellen eine invertierte Schichtstrukturgeometrie und damit einen invertierten Heterokontakt auf. Dabei ist der amorphe Emitter auf der lichtabgewandten Rückseite des Absorbers angeordnet. Da die Intensität des einfallenden Lichtes hinter dem Absorber stark verringert ist, kann von dem Emitter kaum noch Strahlung absorbiert werden, wodurch die Absorptionsverluste gering gehalten werden. Bei der vorgeschlagenen Heterokontakt-Solarzelle befindet sich auf der Vorderseite des Absorbers lediglich eine einzelne dielektrische transparente Antireflexschicht, welche gleichzeitig als elektrisch wirkende Passivierungsschicht dient und dabei eine Ladungsträgerrekombination durch Sättigung von dangling bonds und Ausbildung eines minoritätsladungsträgerrückstreuenden Oberflächenfeldes ("Front Surface Field", FSF), mittels der in der Passivierungsschicht enthaltenen Ladung auf dem Absorber verhindert. Die beschriebene Heterokontakt-Solarzelle benötigt somit keine hochdotierten Silizium-FSF-Schichten an der Vorderseite.

Somit ist bei dieser Form der Heterokontakt-Solarzelle der Emitter nicht, wie in der Druckschrift US 7,199,395 B2, als amorpher, streifenförmiger Emitter, sondern als eine amorphe, über die gesamte Waferrückseite ausgebildete Emitterschicht vorgesehen, welche einfach herstellbar ist und leicht kontaktiert werden kann. Als weiterer Vorteil wird in der Druckschrift WO 2006/111138 A1 herausgestellt, dass es durch die Separation von transparenter Antireflexschicht und Emitter möglich ist, deren Schichtdicken unabhängig voneinander zu optimieren. So kann der Emitter auf der lichtabgewandten Rückseite des Absorbers dicker als auf der lichtzugewandten Vorderseite ausgebildet werden, um eine stabile Raumladungszone zu erzeugen und dadurch die elektronischen Eigenschaften an der Grenzfläche zwischen Emitter und Absorber zu verbessern. Als besonders vorteilhaftes Material für die Ausbildung der Antireflexschicht wird in der Druckschrift WO 2006/111138 A1 Siliziumnitrid vorgeschlagen.

Die auf der Rückseite der bekannten Heterokontakt-Solarzelle vorgesehene andere ohmsche Kontaktierungsstruktur ist großflächig auf dem Emitter ausgebildet. Dabei ist in der Druckschrift WO 2006/111138 A1 explizit ausgeführt, dass zur Kontaktierung des Emitters keine transparente leitfähige Oxidschicht (TCO) als Elektrode mehr benötigt wird. Deren Funktion der Stromableitung wird durch eine direkte ganzflächige Metallisierung realisiert.

Die im Absorber generierten und am Heterokontakt zwischen kristallinem Absorber und amorphen Emitter in der Raumladungszone getrennten Ladungsträger werden bei der bekannten Heterokontakt-Solarzellenstruktur über das an der Solarzellenvorderseite vorgesehene feine Kontaktgitter und die auf der Solarzellenrückseite vorgesehene großflächige Kontaktierungsstruktur abgeführt.

In der Druckschrift EP 1 696 492 A1 ist eine Methode zur Kantenisolierung von Heterokontakt-Solarzellen beschrieben. Dabei ist unter anderem eine Zellkonfiguration mit einer rückseitigen Emitteranordnung aufgeführt. In der beschriebenen Ausführungsform ist auf dem Emitter eine transparente Rückseitenelektrode vorgesehen, auf welcher wiederum voneinander beabstandete, aus leitfähiger Paste ausgebildete Sammelelektroden an der Rückseite der Solarzelle vorgesehen sind. Bezüglich der Funktionsweise dieser Heterokontakt-Solarzelle ist in der Druckschrift EP 1 696 492 A1 ausgeführt, dass der n-Typ-Absorber und die n-Typ-a-Si:H-Schicht zusammen die Elektronen effizienter sammeln würden als der p-Typ-Emitter die Löcher, die in dem Absorber durch Lichteinstrahlung generiert werden. Dies ist jedoch aus physikalischer Sicht unverständlich, da unterschiedliche Sammlungseffizienzen für Elektronen auf der n-Typ-dotierten Seite und der Löcher auf der p-Typ-dotierten Seite zu einer Aufladung des Bauelementes führen würden, was ein Verstoß gegen das Neutralitätsprinzip darstellen würde. Ferner wird in der Druckschrift EP 1 696 492 A1 argumentiert, dass durch die angeblich bessere Elektronensammlung die Metallisierung auf der n-Typ-Seite der Heterokontakt-Solarzelle ausgedünnt werden könnte, wodurch schmalere Busbars und eine geringere Fingeranzahl eingesetzt werden könnten. Somit könnte durch weniger Abschattung ein höherer Strom erzielt werden.

Die oben beschriebenen Heterokontakt-Solarzellen mit rückseitig angeordnetem Emitter besitzen gegenüber Standard-Heterokontakt-Solarzellen den Vorteil, dass die in die Solarzelle eindringende Lichtenergie mit deutlich höherer Effizienz in elektrische Energie umgewandelt werden kann, da hier keine emitterbedingten Absorptionsverluste auftreten. Außerdem kann die beispielsweise in der Druckschrift WO 2006/111138 A1 beschriebene Heterokontakt-Solarzelle mit einer relativ einfachen Technologie umgesetzt werden. Diese Technologie unterscheidet sich jedoch deutlich von der Technologie zur Herstellung von Standard-Heterokontakt-Solarzellen, sodass die bestehenden Anlagenkonzepte geändert werden müssen beziehungsweise einzelne Prozessmodule nicht mehr verwendet und andere wiederum neu installiert werden müssen.

Es ist daher die Aufgabe der vorliegenden Erfindung, ein Heterokontakt-Solarzellenkonzept und eine Technologie zur Herstellung solcher Solarzellen zur Verfügung zu stellen, mit welchen man die emitterbedingten Absorptionsverluste an Heterokontakt-Solarzellen eliminieren und dennoch Standard-Technologien zur Herstellung von Heterokontakt-Solarzellen weiter verwenden kann.

Die Aufgabe wird einerseits durch eine Heterokontakt-Solarzelle der oben genannten Gattung gelöst, bei welcher die Rückseitenkontaktierung eine sich über die Fläche der Rückseite der Heterokontakt-Solarzelle erstreckende Rückseitenkontaktschicht aufweist und die Vorderseitenleitungsschicht einen spezifischen Widerstand in einem Bereich von 7 x 10⁻⁴ bis 50 x 10⁻⁴ Ωcm, bevorzugt von über 11 x 10⁻⁴ Ωcm, vorzugsweise von über 14 x 10⁻⁴ Ωcm, aufweist.

Damit kann zur Herstellung der erfindungsgemäßen Heterokontakt-Solarzelle die gleiche Schrittabfolge wie zur Herstellung einer nicht-invertierten Standard-Heterokontakt-Solarzelle verwendet werden, obwohl sich bei der erfindungsgemäßen Heterokontakt-Solarzelle der Emitter auf der Rückseite, hinter dem Absorber befindet. Durch den auf der Solarzellenrückseite befindlichen Emitter gibt es bei der erfindungsgemäßen Heterokontakt-Solarzelle keine durch den Emitter bedingten Absorptionsverluste. Ferner ist bei der erfindungsgemäßen Heterokontakt-Solarzelle der Emitter ganzflächig vorgesehen, wodurch der Emitter ganzflächig auf der Rückseite der Heterokontakt-Solarzelle kontaktiert werden kann und damit eine relativ einfache Emitterherstellungs- und -kontaktierungstechnologie möglich ist.

In einer bevorzugten Variante der erfindungsgemäßen Heterokontakt-Solarzelle ist zwischen dem Emitter und der Rückseitenkontaktierung eine elektrisch leitfähige, transparente Rückseitenleitungsschicht vorgesehen, die einen spezifischen Widerstand in einem Bereich von 7 x 10⁻⁴ bis 50 x 10⁻⁴ Ωcm, bevorzugt von über 11 x 10⁻⁴ Ωcm, vorzugsweise von über 14 x 10⁻⁴ Ωcm, aufweist.

Somit werden bei der erfindungsgemäßen Heterokontakt-Solarzelle die Vorderseiten- und gegebenenfalls auch die Rückseitenleitungsschicht aus konventionellen TCO-Schichten mit einem relativ hohen spezifischen Widerstand ausgebildet. Da bei der erfindungsgemäßen Heterokontakt-Solarzelle durch die Vorderseitenleitungsschicht Majoritätsladungsträger gesammelt werden, wird die Leitfähigkeit der Vorderseitenleitungsschicht (vorderseitige TCO-Schicht) durch die Leitfähigkeit des Absorbers (Substrates) unterstützt. Bedingt durch die Querleitfähigkeit des Absorbers kann der Strom von Majoritätsladungsträgern durch den Querschnitt der Zelle bis zu den auf der Vorderseite befindlichen Kontaktstrukturen (Kontaktfingern) der Vorderseitenkontaktierung geleitet werden, sodass an die Leitfähigkeit der Vorderseitenleitungsschicht keine hohen Anforderungen gestellt werden müssen. Entsprechend kann die Vorderseitenleitungsschicht (vorderseitige TCO-Schicht) mit einer hohen Transparenz ausgebildet werden, ohne den Serienwiderstand der Solarzelle negativ zu beeinflussen. Durch die Optimierung der Transparenz der Vorderseitenleitungsschicht können die Werte für die Kurzschlussstromdichte J_{SC} der erfindungsgemäßen Heterokontakt-Solarzelle verbessert werden. Da die Transparenz von TCO-Schichten sich umgekehrt proportional zu der Leitfähigkeit solcher Schichten verhält, kann, weil die Leitfähigkeit der Vorderseitenleitungsschicht durch die Unterstützung der Leitfähigkeit des Absorbers gering gehalten werden kann, die Vorderseitenleitungsschicht der erfindungsgemäßen Heterokontakt-Solarzelle in dem erfindungsgemäß vorgeschlagenen Widerstandsbereich mit einer hohen optischen Transparenz ausgebildet werden.

In der vorliegenden Erfindung kann somit durch die Anordnung des Emitters auf der Solarzellenrückseite eine hochohmige TCO-Schicht (Vorderseitenleitungsschicht) auf der Vorderseite der Solarzelle vorgesehen werden, ohne dass der fill factor (FF) der Solarzelle durch einen erhöhten Serienwiderstand der Solarzelle leidet. Eine solche hochohmige TCO-Schicht würde bei einer Standard-Heterokontakt-Solarzelle zu großen fill factor-Verlusten führen. Da sich der Serienwiderstand der Schichtfolge an der Vorderseite der erfindungsgemäßen Solarzelle aus dem Widerstand der Vorderseitenleitungsschicht (vorderseitige TCO-Schicht) und dem des Absorbers zusammensetzt und da die Leitfähigkeit des Absorbers beispielsweise durch Verwendung niederohmiger Wafer bzw. eines hohen Injektionsniveaus der verwendeten Zellen sehr hoch einstellbar ist, ergibt sich insgesamt ein geringer Serienwiderstand an der Vorderseite der erfindungsgemäßen Heterokontakt-Solarzelle.

Bei der erfindungsgemäßen Heterokontakt-Solarzelle kann die gute Leitfähigkeit des Absorbers ferner zu folgendem Effekt genutzt werden: Standard-Solarzellen mit vorderseitigem Emitter, welche sowohl mit diffundiertem Emitter als auch mit einem Heterokontakt ausgebildet sein können, besitzen immer einen Serienwiderstandsanteil, der in dem Fall einer Standard-Solarzelle mit diffundiertem vorderseitigen Emitter von der Leitfähigkeit des Emitters und in dem Fall einer Heterokontakt-Solarzelle von der Leitfähigkeit der vorderseitigen TCO-Schicht signifikant beeinflusst wird. Dabei ist bei diesen Standard-Solarzellen der Beitrag des Absorbers und der Solarzellenrückseite zum Serienwiderstand sehr gering im Vergleich zu dem Beitrag zum Serienwiderstand, welcher sich aus der geringen Leitfähigkeit der Schichten an der Solarzellenvorderseite, das heißt der Leitfähigkeit des Emitters bei einer Standard-Solarzelle mit diffundiertem Emitter oder der Leitfähigkeit der TCO-Schicht bei einer Standard-Heterokontakt-Solarzelle mit vorderseitigem Emitter, ergibt. Bei den bekannten Standard-Solarzellen muss dieser Serienwiderstandsverlust in Kauf genommen werden, da dieser nicht signifikant zu reduzieren ist. Demgegenüber unterstützt bei der erfindungsgemäßen Heterokontakt-Solarzelle die Leitfähigkeit des Absorbers die Leitfähigkeit der Vorderseitenleitungsschicht (vorderseitige TCO-Schicht). Je nach Leitfähigkeit des zur Ausbildung des Absorbers verwendeten Substrates, welche ohne Weiteres erhöht werden kann, kann der oben genannte Beitrag zum Serienwiderstand der Leitfähigkeit der Solarzellenvorderseite, welche bei der erfindungsgemäßen Heterokontakt-Solarzelle durch die Leitfähigkeit der vorderseitigen TCO-Schicht (Vorderseitenleitungsschicht) und die Leitfähigkeit des Absorbers gemeinsam bestimmt wird, drastisch reduziert werden. Dadurch ist es möglich, die erfindungsgemäße Heterokontakt-Solarzelle mittels einer einfachen planaren Technologie auszubilden, wobei insbesondere auf der Solarzellenrückseite keine Strukturierung unter Ausbildung interdigitierter Bereiche auf der Solarzellenrückseite, wie sie beispielsweise aus der Druckschrift US 7,199,395 B2 bzw. der Druckschrift DE 100 45 249 A1 bekannt sind, erfolgen muss.

Auch auf der Rückseite der erfindungsgemäßen Heterokontakt-Solarzelle kann die dort gegebenenfalls vorgesehene TCO-Schicht (Rückseitenleitungsschicht) grundsätzlich mit relativ geringer elektrischer Leitfähigkeit ausgebildet werden, da die Solarzellenrückseite ganzflächig über die dort vorgesehene Rückseitenkontaktschicht, wie beispielsweise eine Metallschicht, elektrisch kontaktiert ist. Entsprechend kann die Rückseitenleitungsschicht innerhalb des erfindungsgemäß vorgesehenen Widerstandsbereiches ebenfalls mit einer erhöhten Transparenz ausgebildet werden, wodurch insbesondere die IR(Infrarot)-Verluste an der Solarzellenrückseite verringert werden.

Gemäß einer bevorzugten Ausführungsform der erfindungsgemäßen Heterokontakt-Solarzelle weisen die Vorderseitenleitungsschicht und die Rückseitenleitungsschicht gleiche spezifische optische und elektrische Eigenschaften auf. Hierdurch ist es möglich, die Vorderseitenleitungsschicht und die Rückseitenleitungsschicht aus dem gleichen Material, vorzugsweise unter Verwendung des gleichen Prozesses, herstellen zu können. Man kann somit für die Herstellung der Vorderseitenleitungsschicht und der Rückseitenleitungsschicht die gleiche Abscheidungs-Anlage einsetzen, die relativ einfach ausgebildet sein kann, da es bei dieser Option der Heterokontakt-Solarzelle nicht notwendig ist, die optischen und elektrischen Eigenschaften von Vorderseiten- und Rückseitenleitungsschicht separat einzustellen.

Es ist besonders von Vorteil, wenn die Vorderseitenleitungsschicht und die Rückseitenleitungsschicht gleiche Dotierungen und damit den gleichen spezifischen Widerstand aufweisen. Dies ermöglicht es, die Vorderseitenleitungsschicht und die Rückseitenleitungsschicht in ein und demselben Abscheideprozess unter Verwendung gleicher Materialien und gleicher Dotierungen herzustellen. Damit ist eine besonders effiziente Herstellbarkeit der erfindungsgemäßen Heterokontakt-Solarzelle gewährleistet. Außerdem können Transparenz und elektrische Eigenschaften der Vorderseitenleitungsschicht und der Rückseitenleitungsschicht auf gleiche Weise, gemeinsam gezielt eingestellt werden und damit die Schichteigenschaften beider Schichten optimiert werden.

Bei einer anderen Variante der erfindungsgemäßen Heterokontakt-Solarzelle können die Vorderseitenleitungsschicht und die Rückseitenleitungsschicht auch unterschiedlich dotiert sein. Hierdurch können die optischen und elektrischen Eigenschaften und Vorderseiten- und Rückseitenleitungsschicht unterschiedlich eingestellt werden.

Vorzugsweise weisen die Vorderseitenleitungsschicht und die Rückseitenleitungsschicht im Wellenlängenbereich von 550 nm bis 1200 nm eine Transmission von über 85% auf. Bei derart transparenten Vorderseiten- und Rückseitenleitungsschichten kann eine hohe Effizienz der erfindungsgemäßen Heterokontakt-Solarzelle erreicht werden, da hierdurch einerseits die Kurzschlussstromdichte optimiert werden kann und andererseits optische Verluste im Infrarot auf der Solarzellenrückseite verringert werden können.

In einer speziellen Ausführungsvariante der vorliegenden Erfindung weist die Rückseitenleitungsschicht der Heterokontakt-Solarzelle im infraroten Spektralbereich eine größere Transmission als die Vorderseitenleitungsschicht auf. Hierdurch werden die optischen Verluste im Infrarot auf der Rückseite der Solarzelle verringert, während die Vorderseitenleitungsschicht mit optimierten optischen und elektrischen Eigenschaften zur Verfügung gestellt werden kann.

Gemäß einer weiteren Option der erfindungsgemäßen Heterokontakt-Solarzelle umfassen die Vorderseitenleitungsschicht und die Rückseitenleitungsschicht wenigstens eine Indium-Zinn-Oxid-Schicht (ITO-Schicht). ITO-Schichten besitzen eine sehr gute Transparenz bei gleichzeitig hoher elektrischer Leitfähigkeit und sind somit sehr gut geeignet, um eine Heterokontakt-Solarzelle mit hoher Effizienz zur Verfügung zu stellen.

In einer anderen Variante der vorliegenden Erfindung kann die Vorderseitenleitungsschicht und die Rückseitenleitungsschicht der Heterokontakt-Solarzelle wenigstens eine mit Aluminium dotierte Zink-Oxid-Schicht (ZnO:AI-Schicht) umfassen. ZnO:Al ist preiswerter als ITO, besitzt jedoch eine geringere Transparenz, wenn die Schicht so gut leitfähig sein soll, dass ihre Leitfähigkeit für eine Heterokontakt-Solarzelle ausreichend ist. Da, wie oben erörtert, die Leitfähigkeit der Vorderseiten- und der Rückseitenleitungsschicht bei der erfindungsgemäßen Heterokontakt-Solarzelle durchaus geringer als die von TCO-Schichten herkömmlicher Heterokontakt-Solarzellen sein kann, kann die Dotierung der ZnO-Schicht gering eingestellt und damit eine hohe Transparenz erreicht werden. Damit kann die Verwendung von mit Aluminium dotierten Zink-Oxid-Schichten für die Ausbildung der Vorderseiten- und Rückseitenleitungsschichten durchaus lukrativ sein.

Günstig kann es auch sein, wenn die Vorderseitenleitungsschicht und die Rückseitenleitungsschicht der erfindungsgemäßen Heterokontakt-Solarzelle wenigstens eine Indium-Oxid-Schicht (IO-Schicht) umfassen. Auch IO-Schichten können mit einem guten Verhältnis von Leitfähigkeit und Transparenz ausgebildet werden.

In einer bevorzugten Ausgestaltung der erfindungsgemäßen Heterokontakt-Solarzelle ist der erste Leitungstyp, also der Leitungstyp des Absorbers und der vorderseitig auf dem

Absorber vorgesehenen dotierten amorphen Halbleiterschicht, durch eine n-Dotierung und der zweite Leitungstyp, das heißt der Leitungstyp der Emitterschicht, durch eine p-Dotierung ausgebildet. Obwohl es grundsätzlich auch möglich ist, den Absorber p-Typ und den Emitter n-Typ zu dotieren, ist die oben vorgeschlagene Variante einer Heterokontakt-Solarzelle besonders effektiv, da ein n-leitender Absorber aus Silizium sehr gute Transporteigenschaften und eine hohe Ladungsträgerlebensdauer aufweist. Die Majoritätsladungsträger, die bei einem n-leitenden Absorber Elektronen sind, können somit vorteilhaft durch den Absorber zur Vorderseitenkontaktierung geleitet werden.

Gemäß einer bevorzugten Ausbildung der erfindungsgemäßen Heterokontakt-Solarzelle ist zwischen dem Absorber und der vorderseitig vorgesehenen dotierten amorphen Halbleiterschicht und/oder zwischen dem Absorber und dem Emitter eine amorphe intrinsische, das heißt undotierte, Halbleiterschicht vorgesehen. Die intrinsische Halbleiterschicht ist typischerweise sehr dünn, das heißt mit einer Schichtdicke von wenigen Nanometern, ausgebildet. Durch die zusätzlich vorgesehene(n) intrinsische(n) Halbleiterschicht(en) wird die Grenzflächencharakteristik zwischen den jeweiligen Schichten verbessert und Effizienzverluste werden reduziert, da in den intrinsischen Schichten nur minimale Defekte vorliegen, an welchen Rekombinationen von erzeugten Ladungsträgern stattfinden können.

Beispielsweise ist die amorphe intrinsische Halbleiterschicht eine wasserstoffhaltige amorphe Siliziumschicht.

Günstigerweise ist die amorphe dotierte Halbleiterschicht und/oder die Emitterschicht eine wasserstoffhaltige Siliziumschicht oder eine SiOₓ-Schicht mit x ≤ 2. Dabei sind die amorphe dotierte Halbleiterschicht und der Emitter entsprechend einander entgegengesetzt dotiert.

Es ist besonders von Vorteil, wenn bei der erfindungsgemäßen Heterokontakt-Solarzelle der Emitter unstrukturiert, das heißt als eine durchgehende Schicht, ausgebildet ist. Damit kann der Emitter besonders leicht hergestellt und nachfolgend kontaktiert werden.

Die Aufgabe der Erfindung wird ferner durch ein Verfahren zum Herstellen einer Heterokontakt-Solarzelle gemäß der oben angegebenen Gattung gelöst, wobei zur Abscheidung der Vorderseitenleitungsschicht solche Materialien gewählt werden, dass der spezifische Widerstand dieser Schicht in einem Bereich von 7 x 10⁻⁴ bis 50 x 10⁻⁴ Ωcm, bevorzugt von über 11 x 10⁻⁴ Ωcm, vorzugsweise von über 14 x 10⁻⁴ Ωcm, liegt, und die Rückseitenkontaktierung als eine sich über die Fläche der Rückseite der Heterokontakt-Solarzelle erstreckende Rückseitenkontaktschicht abgeschieden wird.

In einer bevorzugten Ausführungsform des erfindungsgemäßen Verfahrens wird darüber hinaus zwischen dem Emitter und der Rückseitenkontaktierung eine elektrisch leitfähige, transparente Rückseitenleitungsschicht ausgebildet, wobei zur Abscheidung der Rückseitenleitungsschicht solche Materialien gewählt werden, dass der spezifische Widerstand dieser Schicht in einem Bereich von 7 x 10⁻⁴ bis 50 x 10⁻⁴ Ωcm, bevorzugt von 11 x 10⁻⁴ Ωcm, vorzugsweise von über 14 x 10⁻⁴ Ωcm, liegt.

Dabei ist es ganz besonders von Vorteil, wenn die Vorseitenleitungsschicht und die Rückseitenleitungsschicht gleichzeitig in der gleichen Abscheidekammer erzeugt werden.

Bei dem erfindungsgemäßen Verfahren werden somit Standardprozesse zur Herstellung von Heterokontakt-Solarzellen genutzt, jedoch mit dem Unterschied, dass mit dem erfindungsgemäßen Verfahren eine invertierte Heterokontakt-Solarzelle hergestellt wird, bei welcher der Emitter auf der Rückseite, das heißt auf der lichtabgewandten Seite, der Heterokontakt-Solarzelle angeordnet ist. Dabei werden im Unterschied zu der in der WO 2006/111138 A1 beschriebenen Technologie sowohl auf der Vorder- als auch auf der Rückseite der Heterokontakt-Solarzellenstruktur elektrisch leitfähige transparente Schichten, das heißt typischerweise TCO-Schichten, ausgebildet. Die als Vorderseiten- bzw. Rückseitenleitungsschichten beschriebenen TCO-Schichten weisen einen relativ hohen spezifischen Widerstand auf. Dies wirkt sich vorliegend jedoch nicht nachteilig aus, da der Absorber eine derart hohe Leitfähigkeit besitzt, dass die geringe Leitfähigkeit der Vorderseitenleitungsschicht auf der Solarzellenvorderseite hiermit kompensiert werden kann. Auch auf der Rückseite der Solarzelle ist der relativ große spezifische Widerstand der Rückseitenleitungsschicht nicht kritisch, da dieser durch die sich über die gesamte Fläche der Rückseite der Heterokontakt-Solarzelle erstreckende Rückseitenkontaktschicht kompensiert wird.

Dadurch, dass bei dem erfindungsgemäßen Verfahren der Emitter auf der Rückseite der Heterokontakt-Solarzelle, hinter dem Absorber angeordnet wird, gibt es keine emitterbedingten Absorptionsverluste und es kann eine Solarzelle mit hoher Effektivität zur Verfügung gestellt werden. Da der Emitter auf der Solarzellenvorderseite wegfällt, sind an die auf der Vorderseite der Solarzelle, das heißt auf dem Absorber, befindlichen Schichten nicht mehr solch hohe Anforderungen an den Schichtwiderstand zu stellen, wie das bei Standard-Heterokontakt-Solarzellen mit nicht-invertierter Struktur erforderlich ist. So können für die Vorderseitenleitungsschicht durchaus Materialien mit schlechter Leitfähigkeit bei derselben Transparenz, aber beispielsweise geringeren Materialkosten eingesetzt werden. Da zudem auf der Solarzellenrückseite die Rückseitenleitungsschicht mit relativ geringer elektrischer Leitfähigkeit ausgebildet werden kann, kann diese Schicht mit höherer Transparenz, insbesondere im Infrarotbereich, ausgebildet werden. Hierdurch können auf der Solarzellenrückseite die Infrarot-Verluste verringert werden.

Somit kann das erfindungsgemäße Verfahren unter Nutzung bereits bestehender, optimierter Solarzellenherstellungsanlagen und Solarzellenherstellungsprozessschritte durchgeführt werden, wobei dennoch Heterokontakt-Solarzellen hergestellt werden, die durch ihre invertierte Struktur eine erhöhte Effizienz gegenüber herkömmlichen Heterokontakt-Solarzellen aufweisen. Dabei kann der Emitter auf einfache Weise, beispielsweise als unstrukturierte Schicht, auf der Solarzellenrückseite vorgesehen und dort, ebenfalls auf einfache Weise, mittels der sich über die Fläche der Rückseite der Heterokontakt-Solarzelle erstreckenden Rückseitenkontaktschicht kontaktiert werden.

In einem besonders vorteilhaften Ausführungsbeispiel des erfindungsgemäßen Verfahrens werden zum Abscheiden der Vorderseitenleitungsschicht und zum Abscheiden der Rückseitenleitungsschicht Targets aus dem gleichen Material verwendet. Somit können sowohl die Vorderseiten- als auch die Rückseitenleitungsschicht in einem einzigen Prozess in einer Anlage hergestellt werden. Hierdurch können besonders niedrige Produktionskosten für die Herstellung von Heterokontakt-Solarzellen erreicht werden. Auf diese Weise werden Vorderseiten- und Rückseitenleitungsschicht mit den gleichen oder sehr ähnlichen optischen und elektrischen Eigenschaften ausgebildet; es ist von großem Vorteil, wenn das Zellkonzept auch unter diesen Bedingungen die höchste Effizienz erreichen kann.

In einer anderen Variante des erfindungsgemäßen Verfahrens kann es auch günstig sein, wenn zum Abscheiden der Vorderseitenleitungsschicht und der Rückseitenleitungsschicht Targets aus unterschiedlichem Material und/oder mit unterschiedlicher Dotierstoffkonzentration verwendet werden. In diesem Fall können die Eigenschaften der Vorderseitenleitungsschicht einerseits und der Rückseitenleitungsschicht andererseits gezielt eingestellt werden, um für bestimmte Anwendungen optimierte Heterokontakt-Solarzellen herstellen zu können.

Die Targets können beispielsweise aus Indium-Zinn-Oxid, aus mit Aluminium dotiertem Zink-Oxid und/oder aus Indium-Oxid ausgewählt werden. Darüber hinaus gibt es jedoch noch eine Vielzahl weiterer geeigneter Materialien, um die Vorderseitenleitungsschicht und die Rückseitenleitungsschicht herzustellen. Die oben genannten TCO-Materialien zeichnen sich jedoch durch ihre vorteilhaften optischen und elektrischen Eigenschaften aus, wobei insbesondere mit Aluminium dotiertes Zink-Oxid zudem mit relativ geringen Kosten verbunden ist.

In einer weiteren Ausführungsform des erfindungsgemäßen Verfahrens ist der in der Abscheidekammer verwendete O₂-Fluss bei der Abscheidung der Vorderseitenleitungsschicht und der Abscheidung der Rückseitenleitungsschicht bzw. die O₂-Konzentration, die zur Dotierung dieser Schichten verwendet wird, gleich. Dadurch ist die Dotierung der TCO-Schichten (Vorderseiten- und Rückseitenleitungsschicht) an der Vorder- und Rückseite der ausgebildeten Heterokontakt-Solarzelle gleich oder sehr ähnlich. Damit kann bei der Abscheidung der Vorderseiten- und der Rückseitenleitungsschicht in einer einzigen Kammer ohne Gastrennungen nur eine einzige Sauerstoffgaszuführung eingesetzt werden, wodurch die Anlagen- als auch die Prozesskosten gering gehalten werden können. Dabei werden Vorderseitenleitungsschicht und Rückseitenleitungsschicht bei gleichen Gasbedingungen abgeschieden und somit mit gleichen oder sehr ähnlichen elektrischen und optischen Eigenschaften ausgebildet. Letzteres ist bei der Herstellung von Heterokontakt-Solarzellen gemäß dem Stand der Technik eher nachteilig, da man dort die TCO-Schicht an der Solarzellenvorderseite möglichst leitfähig ausbilden will und somit an der Solarzellenrückseite auch eine leitfähige TCO-Schicht erzeugt, wodurch wiederum Infrarot-Verluste an der Solarzellenrückseite entstehen. Da man bei dem erfindungsgemäßen Verfahren die TCO-Schicht an der Solarzellenvorderseite, das heißt die transparente Vorderseitenleitungsschicht, weniger leitfähig und dafür transparenter machen kann, weil die Leitfähigkeit des Absorbers die Leitfähigkeit der transparenten Vorderseitenleitungsschicht unterstützt, ist bei dem erfindungsgemäßen Verfahren auch die TCO-Schicht an der Solarzellenrückseite, das heißt die Rückseitenleitungsschicht, transparenter ausbildbar, wodurch die Infrarot-Verluste an der Solarzellenrückseite verringert werden können.

Bevorzugte Ausführungsformen der vorliegenden Erfindung, deren Aufbau, Funktion und Vorteile werden im Folgenden anhand von Figuren näher erläutert, wobei
- Figur 1: schematisch einen möglichen Aufbau einer erfindungsgemäßen Hetero-kontakt-Solarzelle in einem Querschnitt durch deren Schichtaufbau zeigt; und
- Figur 2: schematisch einen möglichen Prozessablauf zur Herstellung einer erfindungsgemäßen Heterokontakt-Solarzelle entsprechend dem erfindungsgemäßen Verfahren zeigt.

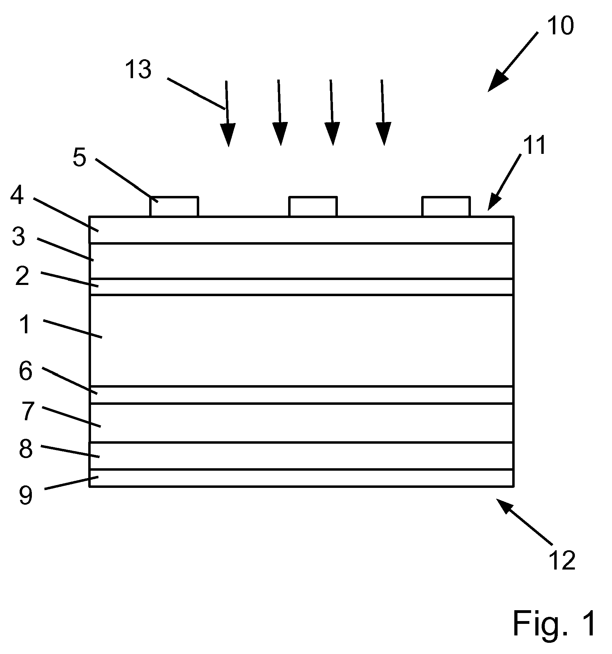

Figur 1 zeigt schematisch eine Ausführungsform einer erfindungsgemäßen Heterokontakt-Solarzelle 10 in einem Querschnitt durch ihre Schichtfolge.

Die Heterokontakt-Solarzelle 10 weist eine Vorderseite 11 auf, in welche ein Einfall von Solarstrahlung 13 vorgesehen ist. Die der Vorderseite 11 gegenüber liegende Seite der Heterokontakt-Solarzelle 10 ist die Rückseite 12.

Die Heterokontakt-Solarzelle 10 weist ein Substrat bzw. einen Absorber 1 auf. In dem gezeigten Ausführungsbeispiel ist der Absorber 1 n-dotiert und besteht aus kristallinem Silizium. In anderen, nicht gezeigten Ausführungsformen der vorliegenden Erfindung kann der Absorber 1 auch aus einem anderen halbleitenden Material bestehen. Vorzugsweise ist dieses Material monokristallin, kann jedoch auch poly-, multi- oder mikrokristallin sein. Ferner kann der Absorber 1 in anderen Varianten der vorliegenden Erfindung auch p-dotiert sein. Dabei bestehen unterschiedlichste Möglichkeiten bei der Wahl der jeweils verwendeten Dotanten. Beispielsweise kann der in Figur 1 dargestellte Absorber 1 mit Phosphor n-dotiert sein.

Auf der vorderseitigen Oberfläche des Absorbers 1 ist in dem in Figur 1 dargestellten Ausführungsbeispiel eine amorphe intrinsische, das heißt nicht dotierte, Halbleiterschicht 2 vorgesehen. Die Halbleiterschicht 2 ist in dem dargestellten Ausführungsbeispiel eine amorphe intrinsische, mit Wasserstoff angereicherte Siliziumschicht, kann jedoch auch in anderen Ausführungsformen der vorliegenden Erfindung, je nach verwendetem Absorbermaterial, aus einem anderen geeigneten amorphen intrinsischen Halbleitermaterial ausgebildet sein.

In anderen, nicht gezeigten Ausführungsformen der vorliegenden Erfindung kann auch auf die amorphe intrinsische Halbleiterschicht 2 verzichtet werden.

Auf der amorphen, intrinsischen Halbleiterschicht 2 ist in dem Ausführungsbeispiel von Figur 1 eine n⁺-dotierte amorphe Halbleiterschicht 3 vorgesehen. Das heißt, die dotierte amorphe Halbleiterschicht 3 weist eine höhere Dotierung als der Absorber 1 auf. In dem in Figur 1 dargestellten Ausführungsbeispiel besteht die dotierte amorphe Halbleiterschicht 3 aus mit Wasserstoff angereichertem amorphen Silizium (a-Si:H) mit einer n-Typ-Dotierung, wie beispielsweise einer Phosphor-Dotierung. In anderen, nicht gezeigten Ausführungsformen der vorliegenden Erfindung können, je nach Wahl des Materials für den Absorber 1, für die dotierte amorphe Halbleiterschicht 3 auch andere geeignete Halbleitermaterialien und/oder andere geeignete Dotanten eingesetzt werden.

Oberhalb der dotierten amorphen Halbleiterschicht 3 ist auf der Vorderseite 11 der Heterokontakt-Solarzelle 10 eine transparente Vorderseitenleitungsschicht 4 vorgesehen. Die transparente Vorderseitenleitungsschicht 4 ist eine TCO (Transparent Conductive Oxide)-Schicht. Die transparente Vorderseitenleitungsschicht 4 besteht in dem in Figur 1 dargestellten Ausführungsbeispiel aus mit Aluminium dotiertem Zink-Oxid, kann jedoch in anderen, nicht gezeigten Ausführungsformen der vorliegenden Erfindung auch beispielsweise eine Indium-Zinn-Oxid-Schicht oder auch eine Indium-Oxid-Schicht sein.

Die transparente Vorderseitenleitungsschicht 4 weist einen Schichtwiderstand in einem Bereich von 7 x 10⁻⁴ bis 50 x 10⁻⁴ Ωcm auf. Die Schichtdicke der Vorderseitenleitungsschicht ist auf λ/4n der in die Heterokontakt-Solarzelle 10 einfallenden Lichtstrahlung optimiert, wobei n der Brechungsindex der Vorderseitenleitungsschicht 4 ist. In dem gezeigten Ausführungsbeispiel beträgt die Schichtdicke der transparenten Vorderseitenleitungsschicht 4 zwischen 70 und 120 nm.

Ferner ist auf der Vorderseite 11 der Heterokontakt-Solarzelle 10 auf der transparenten Vorderseitenleitungsschicht 4 eine Vorderseitenkontaktierung mit mehreren, voneinander beabstandeten Kontaktstrukturen 5 vorgesehen. Die Kontaktstrukturen 5 werden in der Fachwelt häufig auch als Kontaktfinger bezeichnet. Die Kontaktstrukturen 5 können beispielsweise aus Silber ausgebildet sein. Grundsätzlich kommen jedoch auch andere, gut leitfähige Materialien, wie Metalle, zur Ausbildung der Kontaktstrukturen 5 in Betracht.

Auf der rückseitigen Oberfläche des Absorbers 1 ist bei der Heterokontakt-Solarzelle 10 aus Figur 1 eine dünne intrinsische, das heißt nicht dotierte, amorphe Halbleiterschicht 6 vorgesehen. Die intrinsische amorphe Halbleiterschicht 6 hat gleiche bzw. ähnliche Eigenschaften wie die oben beschriebene intrinsische amorphe Schicht 2, daher sei an dieser Stelle auf die obigen Ausführungen zu der intrinsischen amorphen Halbleiterschicht 2 verwiesen, welche auch für die intrinsische amorphe Halbleiterschicht 6 gelten. In anderen, nicht gezeigten Ausführungsformen der Erfindung kann die intrinsische amorphe Halbleiterschicht 6 auch weggelassen werden.

Auf der intrinsischen amorphen Halbleiterschicht 6 ist ein Emitter 7 vorgesehen. Der Emitter 7 besteht in dem Beispiel von Figur 1 aus p⁺-dotiertem amorphen Silizium. In dem gezeigten Ausführungsbeispiel besteht der Emitter 7 aus mit Wasserstoff angereichertem amorphen Silizium (a-Si:H) mit einer p-Typ-Dotierung. Der Emitter 7 befindet sich aus Sicht der in die Heterokontakt-Solarzelle 10 einfallenden Solarstrahlung 13 hinter dem Absorber 1. Somit kann durch den Emitter 7 praktisch kein in den Absorber 1 eintretendes Licht absorbiert werden. Entsprechend ist es möglich, den Emitter 7 mit einer geeigneten Dicke auszubilden, was dann, wenn der Emitter, wie es bei Standard-Heterokontakt-Solarzellen der Fall ist, auf der Vorderseite ausgebildet ist, nur beschränkt möglich ist, um die Absorptionsverluste durch den Emitter gering zu halten. Außerdem kann der Emitter 7 mit einer relativ hohen Dotierung versehen werden, sodass er eine vorteilhafte elektrische Leitfähigkeit besitzt. Letzteres ist bei Standard-Heterokontakt-Solarzellen auch nicht möglich, da erhöhte Dotierungen zu einer schlechteren Transparenz führen, welche wiederum auf der Solarzellenvorderseite negativ ist, aber bei der vorliegenden Erfindung für den Emitter 7 ohne Belang ist, da er sich auf der lichtabgewandten Seite der Heterokontakt-Solarzelle 10 hinter dem Absorber 1 befindet. Der Emitter 7 ist in dem Beispiel von Figur 1 als eine durchgehende Schicht auf dem Absorber 1 vorgesehen.

Auf der rückseitigen Oberfläche des Emitters 7 ist bei der Heterokontakt-Solarzelle 10 eine Rückseitenleitungsschicht 8 vorgesehen. Die Rückseitenleitungsschicht 8 ist eine TCO-Schicht, das heißt, sie ist eine elektrisch leitfähige, transparente Oxidschicht. In dem Ausführungsbeispiel von Figur 1 besteht die Rückseitenleitungsschicht 8 aus mit Aluminium dotiertem Zink-Oxid. In anderen, nicht gezeigten Ausführungsformen der vorliegenden Erfindung kann für die Ausbildung der Rückseitenleitungsschicht 8 auch eine Indium-Zinn-Oxid-Schicht (ITO-Schicht), eine Indium-Oxid-Schicht oder eine andere geeignete TCO-Schicht verwendet werden.

Die Rückseitenleitungsschicht 8 weist insbesondere im Infrarot-Bereich eine hohe Transparenz auf. Vorzugsweise beträgt die Transmission der oben beschriebenen Vorderseitenleitungsschicht 4 und der Rückseitenleitungsschicht 8 im Wellenlängenbereich von 550 nm bis 1200 nm über 85%.

Die Rückseitenleitungsschicht 8 ist als unstrukturierte Schicht auf der Emitterschicht 7 vorgesehen. Sie dient als Elektrode zum Sammeln der in der Raumladungszone zwischen Absorber 1 und Emitter 7 generierten und getrennten Ladungsträger. Diese Ladungsträger werden von der Rückseitenleitungsschicht 8 an die auf der Rückseitenleitungsschicht 8 an der Rückseite 12 der Heterokontakt-Solarzelle 10 vorgesehene Rückseitenkontaktierung weitergeleitet. Die Rückseitenkontaktierung der Heterokontakt-Solarzelle 10 besteht in dem Ausführungsbeispiel von Figur 1 aus einer sich über die gesamte Fläche der Rückseitenleitungsschicht 8 erstreckenden Rückseitenkontaktschicht 9. Die Rückseitenkontaktschicht 9 kann beispielsweise aus Silber ausgebildet sein. Grundsätzlich eignen sich für die Ausbildung der Rückseitenkontaktschicht 9 jedoch auch weitere, sehr gut elektrisch leitende Materialen, wie verschiedene Metalle.

In anderen, nicht gezeigten Ausführungsformen der vorliegenden Erfindung kann die Rückseitenleitungsschicht 8 auch weggelassen werden und somit die Rückseitenkontaktschicht 9 direkt auf dem Emitter 7 ausgebildet werden. In diesem Fall, in welchem die als Rückseitenleitungsschicht 8 oben beschriebene TCO-Schicht an der Rückseite der Solarzelle weggelassen wird, ist eine ganzflächige Metallisierung, das heißt eine ganzflächige Abscheidung der Rückseitenkontaktschicht 9, an der Solarzellenrückseite notwendig. Wenn allerdings, wie oben beschrieben, eine Rückseitenleitungsschicht 8 zwischen dem Emitter 7 und der Rückseitenkontaktschicht 9 vorgesehen wird, ist es möglich, die Rückseitenkontaktschicht 9 als ganzflächige Metallisierung oder auch als Struktur mit Fingern, wie die Kontaktstrukturen 5 auf der Solarzellenvorderseite, auszubilden.

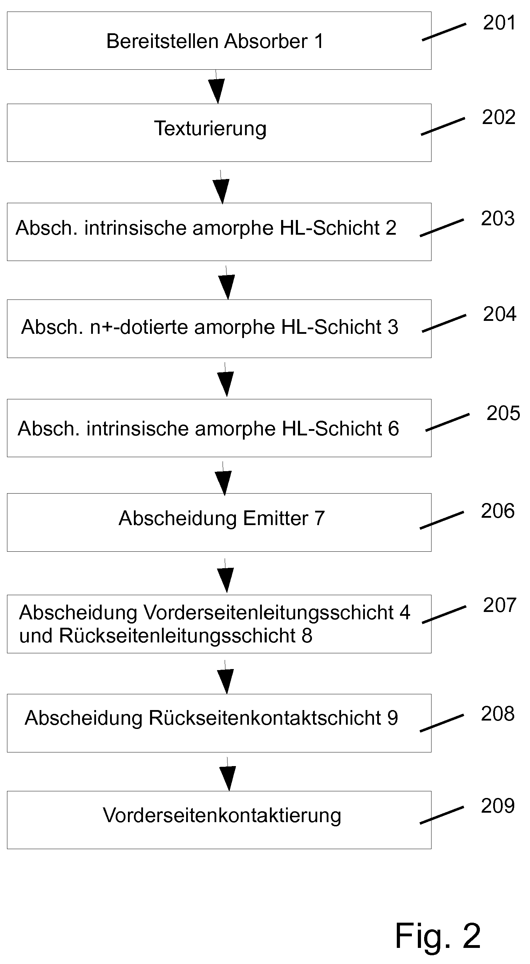

Figur 2 zeigt schematisch eine mögliche Prozessabfolge zur Ausführung des erfindungsgemäßen Verfahrens zur Herstellung einer Heterokontakt-Solarzelle 10, wie sie beispielsweise in Figur 1 schematisch dargestellt ist.

In der Prozessfolge von Figur 2 wird zunächst in einem Schritt 201 ein Absorber 1 bereit gestellt. Der Absorber 1 ist, wie oben bereits ausgeführt, ein geeignetes HalbleiterSubstrat, welches in dem Ausführungsbeispiel von Figur 2 beispielsweise ein n-dotiertes Siliziumsubstrat ist.

In dem Schritt 202 erfolgt unter anderem eine Oberflächenpräparation des Absorbers 1, wodurch die Oberfläche des Absorbers 1 texturiert wird. Die Texturierung dient dazu, die Lichtabsorption in der auszubildenden Heterokontakt-Solarzelle 10 zu erhöhen, indem deren Reflexion verringert wird. Nach der Texturierung erfolgt eine Reinigung in mehreren Schritten.

In dem sich anschließenden Prozessschritt 203 wird auf der Vorderseite des Absorbers 1 die intrinsische amorphe Schicht 2 in Form einer dünnen, mit Wasserstoff angereicherten, amorphen intrinsischen Siliziumschicht abgeschieden.

Danach folgt im Schritt 204 eine Abscheidung der dotierten amorphen Halbleiterschicht 3 auf der intrinsischen amorphen Schicht 2. Die dotierte amorphe Halbleiterschicht 3 ist in dem gezeigten Ausführungsbeispiel n⁺-dotiert.

Im Prozessschritt 205 wird auf die Rückseite des Absorbers 1 eine intrinsische amorphe Halbleiterschicht 6 in Form einer mit Wasserstoff angereicherten, amorphen intrinsischen Siliziumschicht abgeschieden. Auf die intrinsische amorphe Halbleiterschicht 6 wird im Prozessschritt 206 der p⁺-dotierte, aus mit Wasserstoff angereicherten amorphen Silizium bestehende Emitter 7 abgeschieden.

In anderen, ebenfalls geeigneten Verfahrensoptionen des erfindungsgemäßen Verfahrens kann die oben beschriebene Schrittabfolge zur Abscheidung der intrinsischen und der dotierten amorphen Halbleiterschichten 2, 3, 6 und 7 auch in einer anderen Abfolge vorgenommen werden. So kann beispielsweise erst auf der Rückseite des Absorbers 1 die intrinsische amorphe Halbleiterschicht 6 und darauf der Emitter 7 abgeschieden werden, während nachfolgend auf der Vorderseite des Absorbers 1 die intrinsische amorphe Halbleiterschicht 2 und darauf die n⁺-dotierte amorphe Halbleiterschicht 3 abgeschieden werden.

Dann werden in einem einzigen Prozessschritt 207 die Vorderseitenleitungsschicht 4 (TCO Vorderseite) und die Rückseitenleitungsschicht 8 (TCO Rückseite) unter Nutzung von einem PVD(physikalische Gasphasenabscheidung)-Prozess abgeschieden. In der beispielhaften Ausführungsform werden die beiden Schichten 4 und 8 in der selben Prozesskammer abgeschieden, mit einer einzigen O₂-Konzentration in der Kammer, welche sowohl die Dotierung der TCO-Schicht an der Vorderseite als auch die der an der Rückseite gleich beeinflusst, mit dem Ergebnis dass die beiden Schichten 4 und 8 gleiche oder sehr ähnliche optische und elektrische Eigenschaften besitzen.

Die Ausbildung der Rückseitenkontaktierung erfolgt durch Abscheidung der Rückseitenkontaktschicht 9 auf der Rückseitenleitungsschicht 8 im Prozessschritt 208 unter Nutzung von PVD-Prozessen oder Siebdruck oder anderen Metallabscheidungsprozesse (z. B. Plating etc.). DieVorderseitenkontaktierung erfolgt in Schritt 209 durch Siebdruck oder andere Metallabscheidungsprozesse (z. B. Plating etc.) von Kontaktierungsstrukturen.

Wie es den oben beschriebenen Schritten entnehmbar ist, sind diese vom Prinzip her sämtlich auch zur Herstellung von Standard-Heterokontakt-Solarzellen einsetzbar. Infolge dessen muss grundsätzlich an den Prozessschritten und den zugehörigen Anlagen zur Herstellung der erfindungsgemäßen Heterokontakt-Solarzelle 10 keine Abwandlung im Vergleich zu Standard-Heterokontakt-Solarzellen-Prozessabläufen vorgenommen werden. Es sind lediglich einfache Prozessparameter-Anpassungen vorzunehmen. Dennoch wird mit der oben beschriebenen Technologie eine invertierte Heterokontakt-Solarzellenstruktur (Back-Heterojunction) geschaffen, bei welcher die emitterbedingten Absorptionsverluste von Standard-Heterokontakt-Solarzellen nicht vorhanden sind und somit die Effizienz der herstellbaren Heterokontakt-Solarzellen 10 sehr hoch ist. Aufgrund dieser Vorteile der erfindungsgemäßen Technologieabfolge und der damit herstellbaren Heterokontakt-Solarzelle 10 kann, beispielsweise zur Minimierung von Kosten, auf die Verwendung verschiedener zwar effizienzerhöhender, aber teurer Materialien verzichtet werden. So kann beispielsweise anstelle von relativ kostenintensiven ITO-Schichten zur Herstellung der transparenten Vorderseitenleitungsschicht 4 bzw. der transparenten Rückseitenleitungsschicht 8 auf kostengünstigere Materialien, wie beispielsweise mit Aluminium dotiertes Zink-Oxid, zurückgegriffen werden.

Durch das erfindungsgemäß verwendete Back-Heterojunction-Sollarzellkonzept kann der Emitter 7 hinsichtlich seiner Schichtdicke und/oder seiner Dotierung unter Ausbildung besonders vorteilhafter elektrischer Eigenschaften, wie beispielsweise maximaler Leerlaufspannung (V_{OC}), optimiert werden. Letzteres ist bei Standard-Heterokontakt-Solarzellen nicht der Fall, da hier immer ein Kompromiss in der Schichtdicke des Emitters zwischen Leerlaufspannung (V_{OC}) und Kurzschlussstromdichte (J_{SC}) gefunden werden muss.

Die erfindungsgemäße Solarzellenherstellungstechnologie ermöglicht es auch, beispielsweise die Rückseite 12 der Heterokontakt-Solarzelle 10 zu polieren. In diesem Fall ist der Vorteil der Rückseitenpolitur bezüglich Rückseitenpassivierung noch größer als in konventionellen Heterojunction-Solarzellen, weil sich der Emitter sich auf der polierten Rückseite befindet: eine geringere Oberfläche als Merkmal für eine bessere Passivierung ist vorteilhafter auf dem Emitter als auf dem dem Emitter gegenüberstehenden Surface Field.

## Patentansprüche

1. Heterokontakt-Solarzelle (10), in deren Vorderseite (11) ein Einfall von Solarstrahlung (13) vorgesehen ist, mit einem aus einem kristallinen Halbleitermaterial eines ersten Leitfähigkeitstyps bestehenden Absorber (1), einer vorderseitig der Heterokontakt-Solarzelle (10) vorgesehenen, höher als der Absorber (1) dotierten amorphen Halbleiterschicht (3) des ersten Leitfähigkeitstyps, einer vorderseitig auf der dotierten amorphen Halbleiterschicht (3) des ersten Leitfähigkeitstyps vorgesehenen transparenten Vorderseitendeckschicht, einer auf der Vorderseite (11) der Heterokontakt-Solarzelle (10) befindlichen, voneinander beabstandete Kontaktstrukturen (5) aufweisenden Vorderseitenkontaktierung, einem rückseitig der Heterokontakt-Solarzelle (10) vorgesehenen Emitter (7) eines zweiten, zum ersten Leitungstyp entgegengesetzten Leitfähigkeitstyps, und einer auf der Rückseite (12) der Heterokontakt-Solarzelle (10) angeordneten Rückseitenkontaktierung, wobei die Vorderseitendeckschicht eine elektrisch leitfähige, transparente Vorderseitenleitungsschicht (4) ist, die zwischen der vorderseitigen, dotierten amorphen Halbleiterschicht (3) und der Vorderseitenkontaktierung vorgesehen ist,
**dadurch gekennzeichnet,**
**dass** die Rückseitenkontaktierung eine sich über die Fläche der Rückseite (12) der Heterokontakt-Solarzelle (10) erstreckende Rückseitenkontaktschicht (9) aufweist; und die Vorderseitenleitungsschicht (4) einen spezifischen Widerstand in einem Bereich von 7 x 10⁻⁴ bis 50 x 10⁻⁴ Ωcm, bevorzugt von über 11 x 10⁻⁴ Ωcm, vorzugsweise von über 14 x 10⁻⁴ Ωcm, aufweist.

2. Heterokontakt-Solarzelle nach Anspruch 1, **dadurch gekennzeichnet, dass** zwischen dem Emitter (7) und der Rückseitenkontaktierung eine elektrisch leitfähige, transparente Rückseitenleitungsschicht (8) vorgesehen ist, die einen spezifischen Widerstand in einen Bereich von 7 x 10⁻⁴ bis 50 x 10⁻⁴ Ωcm, bevorzugt von über 11 x 10⁻⁴ Ωcm, vorzugsweise von über 14 x 10⁻⁴ Ωcm, aufweist.

3. Heterokontakt-Solarzelle nach Anspruch 1 oder 2, **dadurch gekennzeichnet, dass** die Vorderseitenleitungsschicht (4) und die Rückseitenleitungsschicht (8) gleiche spezifische optische und elektrische Eigenschaften aufweisen.

4. Heterokontakt-Solarzelle nach Anspruch 3, **dadurch gekennzeichnet, dass** die Vorderseitenleitungsschicht (4) und die Rückseitenleitungsschicht (8) die gleiche Dotierung und damit den gleichen spezifischen Widerstand aufweisen.

5. Heterokontakt-Solarzelle nach einem der Ansprüche 2 bis 3, **dadurch gekennzeichnet, dass** die Vorderseitenleitungsschicht (4) und die Rückseitenleitungsschicht (8) unterschiedlich dotiert sind.

6. Heterokontakt-Solarzelle nach einem der Ansprüche 2 bis 5, **dadurch gekennzeichnet, dass** die Vorderseitenleitungsschicht (4) und die Rückseitenleitungsschicht (8) im Wellenlängenbereich von 550 nm bis 1200 nm eine Transmission von über 85 % aufweisen.

7. Heterokontakt-Solarzelle nach einem der Ansprüche 2 bis 6, **dadurch gekennzeichnet, dass** die Rückseitenleitungsschicht (8) im infraroten Spektralbereich eine größere Transmission als die Vorderseitenleitungsschicht (4) aufweist.

8. Heterokontakt-Solarzelle nach einem der vorhergehenden Ansprüche, **dadurch gekennzeichnet, dass** die Vorderseitenleitungsschicht (4) und/oder die Rückseitenleitungsschicht (8) wenigstens eine Indium-Zinn-Oxid-Schicht umfassen.

9. Heterokontakt-Solarzelle nach einem der vorhergehenden Ansprüche, **dadurch gekennzeichnet, dass** die Vorderseitenleitungsschicht (4) und/oder die Rückseitenleitungsschicht (8) wenigstens eine mit Aluminium dotierte Zink-Oxid-Schicht umfassen.

10. Heterokontakt-Solarzelle nach einem der vorhergehenden Ansprüche, **dadurch gekennzeichnet, dass** die Vorderseitenleitungsschicht (4) und/oder die Rückseitenleitungsschicht (8) wenigstens eine Indium-Oxid-Schicht umfassen.

11. Heterokontakt-Solarzelle nach einem der vorhergehenden Ansprüche, **dadurch gekennzeichnet, dass** der erste Leitfähigkeitstyp durch eine n-Dotierung und der zweite Leitfähigkeitstyp durch eine p-Dotierung ausgebildet ist.

12. Heterokontakt-Solarzelle nach einem der vorhergehenden Ansprüche, **dadurch gekennzeichnet, dass** zwischen dem Absorber (1) und der vorderseitig vorgesehenen dotierten amorphen Halbleiterschicht (3) und/oder zwischen dem Absorber (1) und dem Emitter (7) eine amorphe intrinsische Halbleiterschicht (2, 6) vorgesehen ist.

13. Heterokontakt-Solarzelle Anspruch 12, **dadurch gekennzeichnet, dass** die amorphe intrinsische Halbleiterschicht (2, 6) eine wasserstoffhaltige amorphe Siliziumschicht ist.

14. Heterokontakt-Solarzelle nach einem der vorhergehenden Ansprüche, **dadurch gekennzeichnet, dass** die amorphe dotierte Halbleiterschicht (3) und/oder der Emitter (7) eine wasserstoffhaltige Siliziumschicht oder eine SiOₓ-Schicht mit x ≤ 2 ist.

15. Heterokontakt-Solarzelle nach einem der vorhergehenden Ansprüche, **dadurch gekennzeichnet, dass** der Emitter (7) unstrukturiert ist.

16. Verfahren zum Herstellen einer Heterokontakt-Solarzelle (10), in deren Vorderseite (11) ein Einfall von Solarstrahlung (13) vorgesehen ist, wobei ein Absorber (1) aus einem kristallinen Halbleitermaterial eines ersten Leitfähigkeitstyps bereitgestellt wird,
vorderseitig der Heterokontakt-Solarzelle (10) eine höher als der Absorber (1) dotierte amorphe Halbleiterschicht (3) des ersten Leitfähigkeitstyps abgeschieden wird,
vorderseitig auf der dotierten amorphen Halbleiterschicht (3) des ersten Leitfähigkeitstyps eine elektrisch leitfähige, transparente Vorderseitenleitungsschicht (4) abgeschieden wird,
auf der Vorderseite (11) der Heterokontakt-Solarzelle (10) eine voneinander beabstandete Kontaktstrukturen (5) aufweisende Vorderseitenkontaktierung erzeugt wird,
rückseitig der Heterokontakt-Solarzelle (10) ein Emitter (7) eines zweiten, zum ersten Leitungstyp entgegengesetzten Leitfähigkeitstyps abgeschieden wird, und auf der Rückseite (12) der Heterokontakt-Solarzelle (10) eine Rückseitenkontaktierung erzeugt wird,
**dadurch gekennzeichnet,**
**dass** zur Abscheidung der Vorderseitenleitungsschicht (4) solche Materialien gewählt werden, dass der spezifische Widerstand dieser Schicht in einem Bereich von 7 x 10⁻⁴ bis 50 x 10⁻⁴ Ωcm, bevorzugt von über 11 x 10⁻⁴ Ωcm, vorzugsweise von über 14 x 10⁻⁴ Ωcm, liegt;
und die Rückseitenkontaktierung als eine sich über die Fläche der Rückseite (12) der Heterokontakt-Solarzelle (10) erstreckende Rückseitenkontaktschicht (9) abgeschieden wird.

17. Verfahren nach Anspruch 16, **dadurch gekennzeichnet, dass** zwischen dem Emitter (7) und der Rückseitenkontaktierung eine elektrisch leitfähige, transparente Rückseitenleitungsschicht (8) ausgebildet wird, wobei zur Abscheidung der Rückseitenleitungsschicht (8) solche Materialien gewählt werden, dass der spezifische Widerstand dieser Schicht in einem Bereich von 7 x 10⁻⁴ bis 50 x 10⁻⁴ Ωcm, bevorzugt von über 11 x 10⁻⁴ Ωcm, vorzugsweise von über 14 x 10⁻⁴ Ωcm, liegt.

18. Verfahren nach Anspruch 17, **dadurch gekennzeichnet, dass** die Vorderseitenleitungsschicht (4) und die Rückseitenleitungsschicht (8) gleichzeitig in der gleichen Abscheidekammer erzeugt werden.

19. Verfahren nach einem der Ansprüche 17 oder 18, **dadurch gekennzeichnet, dass** zum Abscheiden der Vorderseitenleitungsschicht (4) und zum Abscheiden der Rückseitenleitungsschicht (8) Targets aus dem gleichen Material verwendet werden.

20. Verfahren nach Anspruch 17, **dadurch gekennzeichnet, dass** zum Abscheiden der Vorderseitenleitungsschicht (4) und der Rückseitenleitungsschicht (8) Targets aus unterschiedlichem Material und/oder mit unterschiedlicher Dotierstoffkonzentration verwendet werden.

21. Verfahren nach einem der Ansprüche 19 oder 20, **dadurch gekennzeichnet, dass** die Targets aus Indium-Zinn-Oxid, mit Aluminium dotiertem Zink-Oxid und/oder Indium-Oxid ausgewählt werden.

22. Verfahren nach Anspruch 18, **dadurch gekennzeichnet, dass** bei der Abscheidung der Vorderseitenleitungsschicht (4) und der Rückseitenleitungsschicht (8) in der Abscheidekammer die gleiche O₂-Konzentration zur Dotierung dieser Schichten verwendet wird.

23. Verfahren nach einem der Ansprüche 16 bis 22, **dadurch gekennzeichnet, dass** ein rückseitenpolierter Absorber (1) verwendet wird.

## Claims

1. Hetero-contact solar cell (10), a front side (11) of which being provided for an incidence of solar radiation (13), said cell comprising: an absorber (1) of a crystalline semiconductor material of a first conductivity type, an amorphous semiconductor layer (3) of the first conductivity type doped more highly than the absorber (1) and being provided on the front side of the hetero-contact solar cell (10), a front-sided transparent front side cover layer provided on the doped amorphous semiconductor layer (3) of the first conductivity type, a front side contact provided on the front side (11) of the hetero-contact solar cell (10) comprising spaced-apart contact structures (5), an emitter (7) of a second conductivity type being opposite to the first conductivity type provided on the back side of the hetero-contact solar cell (10), and a back side contact provided on the back side (12) of the hetero-contact solar cell (10), wherein
the front side cover layer is an electrically conductive, transparent front side conduction layer (4) being provided between the front-sided, doped amorphous semiconductor layer (3) and the front side contact,
**characterized in that**
the back side contact comprises a back side contact layer (9) extending over the entire surface of the back side (12) of the hetero-contact solar cell (10); and the front side conduction layer (4) comprises a specific resistance in a range from 7 x 10⁻⁴ to 50 x 10⁻⁴ Ωcm, preferred of over 11 x 10⁻⁴ Ωcm, preferably of over 14 x 10⁻⁴ Ωcm.

2. Hetero-contact solar cell according to claim 1, **characterized in that** an electrically conductive, transparent back side conduction layer (8) is provided between the emitter (7) and the back side contact comprising a specific resistance in a range from 7 x 10⁻⁴ to 50 x 10⁻⁴ Ωcm, preferred of over 11 x 10⁻⁴ Ωcm, preferably of over 14 x 10⁻⁴ Ωcm.

3. Hetero-contact solar cell according to claim 1 or 2, **characterized in that** the front side conduction layer (4) and the back side conduction layer (8) comprise the same specific optical and electrical properties.

4. Hetero-contact solar cell according to claim 3, **characterized in that** the front side conduction layer (4) and the back side conduction layer (8) comprise the same doping, and thus the same specific resistance.

5. Hetero-contact solar cell according to one of the claims 2 to 3, **characterized in that** the front side conduction layer (4) and the back side conduction layer (8) are differently doped.

6. Hetero-contact solar cell according to one of the claims 2 to 5, **characterized in that** the front side conduction layer (4) and the back side conduction layer (8) comprise a transmission of over 85% in the wave length range from 550 nm to 1200 nm.

7. Hetero-contact solar cell according to one of the claims 2 to 6, **characterized in that** the back side conduction layer (8) comprises a higher transmission than the front side conduction layer (4) in the infrared spectral range.

8. Hetero-contact solar cell according to one of the preceding claims, **characterized in that** the front side conduction layer (4) and/or the back side conduction layer (8) comprise at least one indium-tin-oxide-layer.

9. Hetero-contact solar cell according to one of the preceding claims, **characterized in that** the front side conduction layer (4) and/or the back side conduction layer (8) comprise at least one aluminum doped zinc-oxide-layer.

10. Hetero-contact solar cell according to one of the preceding claims, **characterized in that** the front side conduction layer (4) and/or the back side conduction layer (8) comprise at least one indium-oxide-layer.

11. Hetero-contact solar cell according to one of the preceding claims, **characterized in that** the first conductivity type is provided by an n-doping and the second conductivity type by a p-doping.

12. Hetero-contact solar cell according to one of the preceding claims, **characterized in that** an amorphous intrinsic semiconductor layer (2, 6) is provided between the absorber (1) and the front-sided doped amorphous semiconductor layer (3) and/or between the absorber (1) and the emitter (7).

13. Hetero-contact solar cell according to claim 12, **characterized in that** the amorphous intrinsic semiconductor layer (2, 6) is a hydrogenous amorphous silicon layer.

14. Hetero-contact solar cell according to one of the preceding claims, **characterized in that** the amorphous doped semiconductor layer (3) and/or the emitter (7) is a hydrogenous silicon layer or a SiOₓ-layer with x ≤ 2.

15. Hetero-contact solar cell according to one of the preceding claims, **characterized in that** the emitter (7) is unstructured.

16. Method for the production of a hetero-contact solar cell (10), in a front side (11) of which an incidence of solar radiation (13) is provided, wherein
an absorber (1) of a crystalline semiconductor material of a first conductivity type is provided,
an amorphous semiconductor layer (3) of the first conductivity type being more highly doped than the absorber (1) is deposited on the front-side of the hetero-contact solar cell (10),
an electrically conductive, transparent front side conduction layer (4) is deposited on the front side of the doped amorphous semiconductor layer (3) of the first conductivity type,
a front side contact comprising spaced-apart contact structures (5) is formed on the front side (11) of the hetero-contact solar cell (10),
an emitter (7) of a second conductivity type opposite to the first conductivity type is deposited on the back side of the hetero-contact solar cell (10), and
a back side contact is formed on the back side (12) of the hetero-contact solar cell (10),
**characterized in that**
such materials are chosen for the deposition of the front side conduction layer (4), that the specific resistance of said layer ranges from 7 x 10⁻⁴ to 50 x 10⁻⁴ Ωcm, preferred of over 11 x 10⁻⁴ Ωcm, preferably of over 14 x 10⁻⁴ Ωcm;
and the back side contact is deposited as a back side contact layer (9) extending over the surface of the back side (12) of the hetero-contact solar cell (10).

17. Method according to claim 16, **characterized in that** an electrically conductive, transparent back side conduction layer (8) is provided between the emitter (7) and the back side contact, wherein such materials are used for the deposition of the back side conduction layer (8) that the specific resistance of said layer ranges from 7 x 10⁻⁴ to 50 x 10⁻⁴ Ωcm, preferred of over 11 x 10⁻⁴ Ωcm, preferably of over 14 x 10⁻⁴ Ωcm.

18. Method according to claim 17, **characterized in that** the front side conduction layer (4) and the back side conduction layer (8) are produced simultaneously in the same deposition chamber.

19. Method according to one of the claims 17 or 18, **characterized in that** targets of the same material are used for the deposition of the front side conduction layer (4) and for the deposition of the back side conduction layer (8).

20. Method according to claim 17, **characterized in that** targets of different material and/or with a different doping material concentration are used for the deposition of the front side conduction layer (4) and the back side conduction layer (8).

21. Method according to one of the claims 19 or 20, **characterized in that** the targets are chosen from indium-tin-oxide, from aluminum doped zinc-oxide and/or from indium-oxide.

22. Method according to claim 18, **characterized in that** for the deposition of the front side conduction layer (4) and of the back side conduction layer (8), the same O₂-concentration is used for doping said layers in the deposition chamber.

23. Method according to one of the claims 16 to 22, **characterized in that** an absorber (1) is used which is polished on its back side.

## Revendications

1. Cellule solaire à hétérocontact (10) dans le côté avant (11) de laquelle est prévue une incidence du rayonnement solaire (13), avec un absorbeur (1) constitué d'un matériau semi-conducteur cristallin ayant un premier type de conductivité, une couche de semi-conducteur (3) amorphe ayant le premier type de conductivité, plus fortement dopée que l'absorbeur (1) et prévue côté avant de la cellule solaire à hétérocontact (10), une couche de couverture côté avant transparente prévue côté avant sur la couche de semi-conducteur (3) amorphe dopée, un système de contact côté avant situé sur le côté avant (11) de la cellule solaire à hétérocontact (10) présentant des structures de contact (5) espacées les unes des autres, un émetteur (7) d'un deuxième type de conductivité opposé au premier type de conductivité prévu côté arrière de la cellule solaire à hétérocontact (10), et un système de contact côté arrière disposé sur le côté arrière (12) de la cellule solaire à hétérocontact (10), dans laquelle la couche de couverture côté avant est une couche de conduction côté avant (4) transparente électriquement conductrice qui est prévue entre la couche de semi-conducteur (3) amorphe dopée côté avant et le système de contact côté avant,
**caractérisée en ce que**
le système de contact côté arrière présente une couche de contact côté arrière (9) s'étendant sur la face du côté arrière (12) de la cellule solaire à hétérocontact (10) ; et la couche de conduction côté avant (4) présente une résistance spécifique dans une plage de 7 x 10⁻⁴ à 50 x 10⁻⁴ Ωcm, de préférence de plus de 11 x 10⁻⁴ Ωcm, préférablement de plus de 14 x 10⁻⁴ Ωcm.

2. Cellule solaire à hétérocontact selon la revendication 1, **caractérisée en ce que,** entre l'émetteur (7) et le système de contact côté arrière, il est prévu une couche de conduction côté arrière (8) transparente électriquement conductrice qui présente une résistance spécifique dans une plage de 7 x 10⁻⁴ à 50 x 10⁻⁴ Ωcm, de préférence de plus de 11 x 10⁻⁴ Ωcm, préférablement de plus de 14 x 10⁻⁴ Ωcm.

3. Cellule solaire à hétérocontact selon la revendication 1 ou 2, **caractérisée en ce que** la couche de conduction côté avant (4) et la couche de conduction côté arrière (8) présentent des propriétés optiques et électriques spécifiques identiques.

4. Cellule solaire à hétérocontact selon la revendication 3, **caractérisée en ce que** la couche de conduction côté avant (4) et la couche de conduction côté arrière (8) présentent le même dopage et donc la même résistance spécifique.

5. Cellule solaire à hétérocontact selon l'une des revendications 2 à 3, **caractérisée en ce que** la couche de conduction côté avant (4) et la couche de conduction côté arrière (8) sont dopées différemment.

6. Cellule solaire à hétérocontact selon l'une des revendications 2 à 5, **caractérisée en ce que** la couche de conduction côté avant (4) et la couche de conduction côté arrière (8) présentent, dans la plage de longueurs d'onde de 550 nm à 1 200 nm, une transmission supérieure à 85 %.

7. Cellule solaire à hétérocontact selon l'une des revendications 2 à 6, **caractérisée en, ce que** la couche de conduction côté arrière (8) présente, dans la plage spectrale infrarouge, une transmission plus importante que la couche de conduction côté avant (4).

8. Cellule solaire à hétérocontact selon l'une des revendications précédentes, **caractérisée en ce que** la couche de conduction côté avant (4) et/ou la couche de conduction côté arrière (8) comprennent au moins une couche d'oxyde d'indium-étain.

9. Cellule solaire à hétérocontact selon l'une des revendications précédentes, **caractérisée en ce que** la couche de conduction côté avant (4) et/ou la couche de conduction côté arrière (8) comprennent au moins une couche d'oxyde de zinc dopée à l'aluminium.

10. Cellule solaire à hétérocontact selon l'une des revendications précédentes, **caractérisée en ce que** la couche de conduction côté avant (4) et/ou la couche de conduction côté arrière (8) comprennent au moins une couche d'oxyde d'indium.

11. Cellule solaire à hétérocontact selon l'une des revendications précédentes, **caractérisée en ce que** le premier type de conductivité est constitué par un dopage n et le deuxième type de conductivité par un dopage p.

12. Cellule solaire à hétérocontact selon l'une des revendications précédentes, **caractérisée en ce que,** entre l'absorbeur (1) et la couche de semi-conducteur (3) amorphe dopée prévue côté avant et/ou entre l'absorbeur (1) et l'émetteur (7), il est prévu une couche de semi-conducteur (2, 6) intrinsèque amorphe.

13. Cellule solaire à hétérocontact selon la revendication 12, **caractérisée en ce que** la couche de semi-conducteur (2, 6) intrinsèque amorphe est une couche de silicium amorphe contenant de l'hydrogène.

14. Cellule solaire à hétérocontact selon l'une des revendications précédentes, **caractérisée en ce que** la couche de semi-conducteur (3) dopée amorphe et/ou l'émetteur (7) est une couche de silicium contenant de l'hydrogène ou une couche SiOₓ, où x ≤ 2.

15. Cellule solaire à hétérocontact selon l'une des revendications précédentes, **caractérisée en ce que** l'émetteur (7) n'est pas structuré.

16. Procédé de fabrication d'une cellule solaire à hétérocontact (10) dans le côté avant (11) de laquelle est prévue une incidence du rayonnement solaire (13), dans lequel un absorbeur (1) est réalisé à partir d'un matériau semi-conducteur cristallin ayant un premier type de conductivité,
une couche de semi-conducteur (3) amorphe ayant le premier type de conductivité plus fortement dopée que l'absorbeur (1) est déposée sur le côté avant de la cellule solaire à hétérocontact (10),
une couche de conduction côté avant (4) transparente électriquement conductrice est déposée sur le côté avant sur la couche de semi-conducteur (3) amorphe dopée ayant le premier type de conductivité,
un système de contact côté avant présentant des structures de contact (5) espacées les unes des autres est produit sur le côté avant (11) de la cellule solaire à hétérocontact (10),
un émetteur (7) ayant un deuxième type de conductivité opposé au premier type de conductivité est déposé sur le côté arrière de la cellule solaire à hétérocontact (10), et un système de contact côté arrière est produit sur le côté arrière (12) de la cellule solaire à hétérocontact (10),
**caractérisé en ce que,**
pour le dépôt de la couche de conduction côté avant (4), il est sélectionné des matériaux tels que la résistance spécifique de cette couche se situe dans une plage de 7 x 10⁻⁴ à 50 x 10⁻⁴ Ωcm, de préférence de plus de 11 x 10⁻⁴ Ωcm, préférablement de plus de 14 x 10⁻⁴ Ωcm ;
et le système de contact côté arrière est déposé en tant que couche de contact côté arrière (9) s'étendant sur la face du côté arrière (12) de la cellule solaire à hétérocontact (10).

17. Procédé selon la revendication 16, **caractérisé en ce que,** entre l'émetteur (7) et le système de contact côté arrière, il est constitué une couche de conduction côté arrière (8) transparente électriquement conductrice, dans lequel, pour le dépôt de la couche de conduction côté arrière (8), il est sélectionné des matériaux tels que la résistance spécifique de cette couche se situe dans une plage de 7 x 10⁻⁴ à 50 x 10⁻⁴ Ωcm, de préférence de plus de 11 x 10⁻⁴ Ωcm, préférablement de plus de 14 x 10⁻⁴ Ωcm.

18. Procédé selon la revendication 17, **caractérisé en ce que** la couche de conduction côté avant (4) et la couche de conduction côté arrière (8) sont produites simultanément dans la même chambre de dépôt.

19. Procédé selon l'une des revendications 17 ou 18, **caractérisé en ce que,** pour le dépôt de la couche de conduction côté avant (4) et pour le dépôt de la couche de conduction côté arrière (8), il est utilisé des cibles réalisées à partir du même matériau.

20. Procédé selon la revendication 17, **caractérisé en ce que,** pour le dépôt de la couche de conduction côté avant (4) et de la couche de conduction côté arrière (8), il est utilisé des cibles réalisées à partir de matériaux différents et/ou ayant des concentrations de dopant différentes.

21. Procédé selon l'une des revendications 19 ou 20, **caractérisé en ce que** les cibles sont sélectionnées à partir d'oxyde d'indium-étain, à partir de l'oxyde de zinc dopé à l'aluminium et/ou à partir d'oxyde d'indium.

22. Procédé selon la revendication 18, **caractérisé en ce que,** lors du dépôt de la couche de conduction côté avant (4) et de la couche de conduction côté arrière (8), la même concentration de O₂ est utilisée dans la chambre de dépôt pour le dopage de ces couches.

23. Procédé selon l'une des revendications 16 à 22, **caractérisé en ce qu**'il est utilisé un absorbeur (1) poli côté arrière.
